Europäisches Patentamt

European Patent Office

Office européen des brevets

(19)

(11) EP 0 678 591 B1

(12) **EUROPÄISCHE PATENTSCHRIFT**

(45) Veröffentlichungstag und Bekanntmachung des Hinweises auf die Patenterteilung:
**03.06.1998 Patentblatt 1998/23**

(51) Int Cl.$^6$: **C23C 14/34**, C23C 14/08

(21) Anmeldenummer: **94118341.0**

(22) Anmeldetag: **22.11.1994**

(54) **Verfahren zur Herstellung Indiumoxid-Zinnoxid Targets**

Process for the production of an indium-tin oxide target

Procédé de production d'une cible en oxyde d'indium-étain

(84) Benannte Vertragsstaaten:
**CH DE FR GB LI NL**

(30) Priorität: **18.04.1994 DE 4413344**

(43) Veröffentlichungstag der Anmeldung:
**25.10.1995 Patentblatt 1995/43**

(73) Patentinhaber: **LEYBOLD MATERIALS GmbH
D-63450 Hanau (DE)**

(72) Erfinder:
• **Schlott, Martin, Dr.
D-63454 Hanau am Main (DE)**
• **Dauth, Wolfgang,
D-60594 Frankfurt a.M. (DE)**
• **Kutzner, Martin
D-63543 Neuberg (DE)**

• **Gehman, Bruce, Dr.
Morgan Hill, CA 95037 (US)**

(56) Entgegenhaltungen:
**EP-A- 0 584 672          DE-A- 4 124 471**

• **PATENT ABSTRACTS OF JAPAN vol. 014 no. 057 (C-0684) ,2.Februar 1990 & JP-A-01 283369 (NIPPON MINING CO LTD) 14.November 1989, & DATABASE WPI Section Ch, Week 8951 Derwent Publications Ltd., London, GB; Class L03, AN 89-375739**
• **THIN SOLID FILMS, Bd. 220, Nr. 1 / 02, 20.November 1992 Seiten 333-336, GEHMAN B L ET AL 'INFLUENCE OF MANUFACTURING PROCESS OF INDIUM TIN OXIDE SPUTTERING TARGETS ON SPUTTERING BEHAVIOR'**

## Beschreibung

Die Erfindung betrifft ein Verfahren zur Herstellung teilreduzierter Sputtertargets für die Kathodenzerstäubung auf der Basis von Indiumoxid-Zinnoxid-Pulvermischungen mittels druckunterstütztem Sintern, wobei $SnO_2$ zusammen mit dem $In_2O_3$ vor dem Verdichten einer Mischbehandlung unterworfen wird.

Oxidkeramische Targets aus Indiumoxid-Zinnoxid (ITO) werden zur Herstellung transparenter, elektrisch leitfähiger, dünner Schichten durch Kathodenzerstäubung (Sputtern) eingesetzt. Anwendung finden solche Schichten vor allem in der Flachbildtechnik. Die Indiumoxid-Zinnoxid-Dünnschichten können entweder durch Sputtern metallischer Targets in sauerstoffreaktiver Atmosphäre oder durch Sputtern oxidkeramischer Targets hergestellt werden.

Der Sputterprozeß mit oxidkeramischen Targets hat den Vorteil, daß die Regelung des Sputterprozesses bei einem nur geringen Sauerstoff-Fluß in der Sputterkammer leichter möglich ist als bei hohen Sauerstoff-Flüssen, wie sie beim Sputtern mit metallischen Targets notwendig sind. Gegenüber volloxidischen Targets aus $In_2O_3 + SnO_2$ bieten Targets, die einen unterstöchiometrischen Sauerstoffgehalt aufweisen den Vorteil, daß der für die Schichtleitfähigkeit entscheidende Sauerstoffgehalt während des Aufsputterns der Schicht in einem größeren Bereich eingestellt werden kann. Außerdem ist der Arbeitsbereich, d.h. der Bereich optimaler Schichtleitfähigkeit, in Abhängigkeit vom Sauerstoff-Fluß bei diesen teilreduzierten Targets breiter als bei volloxidischen Targets.

In der DE-OS 33 00 525 werden teilreduzierte Indiumoxid-Zinnoxid-Targets und ihre Herstellung beschrieben. Danach werden Indiumoxid-Zinnoxid-Pulvergemische unter reduzierten Bedingungen bei 850°C bis 1000°C heiß gepreßt, wobei die Oxide in einer Graphitheißpreßform oder durch Zugabe von Kohlenstoff oder Kohlenstoff freisetzendem organischen Material heiß gepreßt werden. Während des Preßvorgangs werden die Oxide teilweise reduziert, so daß ein Target entsteht, das in seinem Sauerstoffgehalt gegenüber der stöchiometrischen Zusammensetzung abgereichert ist.

Mit diesem Verfahren können Targets mit Dichten < 91 % der theoretischen Dichte (TD), schlechter elektrischer Leitfähigkeit ($\rho = 0,1 - 0,6 \ \Omega cm$) und unzureichender mechanischer Stabilität hergestellt werden. Alle drei Faktoren wirken sich negativ auf den Einsatz als Sputtertarget aus. Darüber hinaus ist es schwierig, den Reduktionsgrad auf diese Weise reproduzierbar und über das Target homogen einzustellen.

In der DE-PS 41 24 471 wird ein oxidkeramisches Target für die Kathodenzerstäubung aus teilweise reduzierten Indiumoxid-Zinnoxid-Gemischen beschrieben, das eine Dichte von mehr als 75 % der theoretischen Dichte und einen spezifischen elektrischen Widerstand zwischen $100 \times 10^{-3}$ und $1 \times 10^{-3} \ \Omega cm$ besitzt, wobei es einen einheitlichem definierten Reduktionsgrad von 0,02 bis 0,30 aufweist, der an keiner Stelle der Targetfläche um mehr als 5 % von dem mittleren Reduktionsgrad des Targets abweicht, wobei der Reduktionsgrad definiert ist als Gewichtsdifferenz zwischen dem stöchiometrischen Oxidgemisch und dem teilreduzierten Oxidgemisch, dividiert durch die Gewichtsdifferenz zwischen dem stöchiometrischen Oxidgemisch und dem vollständig reduzierten, metallischen Gemisch. Bei der Herstellung wird die zinnhaltige Komponente dieses Targets zusammen mit dem $In_2O_3$ vor dem Verdichten einer Mischbehandlung unterworfen.

Es hat sich gezeigt, daß der Schritt der Pulverreduktion sehr zeit- und kostenintensiv ist. Außerdem ist ein hoher Aufwand erforderlich, um eine hinreichend gute Reproduzierbarkeit des Reduktionsgrades zu erzielen.

Es ist daher Aufgabe der vorliegenden Erfindung, ein Verfahren zur Herstellung hochdichter und teilreduzierter Indiumoxid-Zinnoxid-Targets für die Kathodenzerstäubung zu schaffen, bei dem der Reduktionsgrad des Targets auf einfache und reproduzierbare Weise eingestellt werden kann.

Diese Aufgabe wird erfindungsgemäß dadurch gelöst, daß die zinnhaltige Komponente vollständig in Abhängigkeit des geforderten Reduktionsgrades aus SnO und $SnO_2$ gebildet ist.

Durch die erfindungsgemäße Lösung wird erreicht, daß der aufwendige und schwierige Schritt der Pulverreduktion überflüssig wird. Außerdem wird die Einhaltung eines vorgegebenen Reduktionsgrades vereinfacht. Letzteres hat auch große Vorteile bei der Schichtherstellung, da nur bei konstantem Reduktionsgrad des Targets auch mit konstanten Bedingungen bei der Schichtherstellung, insbesondere konstantem Sauerstoff-Fluß im Sputterprozeß, gearbeitet werden kann.

Überraschenderweise hat sich gezeigt, daß über druckunterstützes Sintern von Gemischen aus $In_2O_3$, $SnO_2$ und SnO hochdichte und mechanisch stabile Targets hergestellt werden können, wobei der Reduktionsgrad, definiert als

$$\frac{O_2\left((1-x)\cdot In_2O_3 + x\cdot SnO_2\right) - O_2(\text{Target})}{O_2\left((1-x)\cdot In_2O_3 + x\cdot SnO_2\right)}\cdot 100\%$$

X: Gewichtsanteil an $SnO_2$ des volloxidischen Targets; z.B. x = 0,1 für ITO 90/10

alleine durch den teilweise n oder vollständigen Ersatz von $SnO_2$ durch SnO eingestellt werden kann. Für die üblicherweise verwendete Stöchiometrie 90 gew.% $In_2O_3$ + 10 gew.%$SnO_2$ sind so z.B. Reduktionsgrade zwischen 0 und 6,0 % möglich.

Für das Mischen können konventionelle Verfahren wie Rollenmischer, V-Mischer, Kugelmühlen, Taumelmischer, Trommelmischer o.ä. eingesetzt werden, wobei das Mischen je nach Fließfähigkeit der Pulver naß, z.B. mit $H_2O$ oder organischen Flüssigkeiten oder trocken erfolgen kann. Das druckunterstützte Sintern kann sowohl in einer Heißpresse als auch in einer heißisostatischen Presse erfolgen. Das Kompaktieren sollte dabei zwischen 500°C und 1200°C und bei Drücken von mindestens 100 bar erfolgen. Hohe Dichten werden bevorzugt bei Drücken oberhalb 1000 bar erreicht. Die nachfolgenden Beispiele sollen die erfindungsgemäße Herstellung der Targets näher erläutern:

**1. Beispiel:**

Für eine 6 % reduzierte ITO (10) Mischung wurden 900 g $In_2O_3$ und 89,4 g SnO während 60 min in einem Taumelmischer gemischt. Das so erhaltene Pulver wurde zunächst kaltisostatisch vorgepreßt und anschließend in einer ausgekleideten Stahlkanne bei 850°C und 200 MPa für 3h in einer heißisostatischen Presse kompaktiert. Der erhaltene Indiumoxid-Zinnoxid-Körper hatte eine Dichte von 6,87 g/cm$^3$ entsprechend 96 % der theoretischen Dichte und wies einen Reduktionsgrad von 5,9 % auf. Die mechanische Bearbeitung konnte problemlos durchgeführt werden.

Während des Sputterns des Targets wurde kein "Arcing" beobachtet. Die Sputterraten waren vergleichbar mit denen, die man für andere hochdichte teilreduzierte ITO-Targets findet.

**2. Beispiel:**

Für eine 6 % reduzierte ITO (19) Mischung wurden 900 g $In_2O_3$ und 89,4 g SnO während 30 min in einer Kugelmühle unter Zugabe von Keramikkugeln gemischt. Das so erhaltene Pulver wurde in eine mit BN beschichtete Graphitform geschüttet und anschließend bei 900°C unter Argonatmosphäre in einer Heißpresse mit einem maximalen Preßdruck von 180 MPa verdichtet. Die so erhaltene Scheibe wies eine Dichte von 6,37 g/cm$^3$ entsprechend 89 % der theoretischen Dichte auf. Der analysierte Reduktionsgrad betrug 6,8 %. Die mechanische Bearbeitung konnte problemlos durchgeführt werden. Während des Sputterns des Targets wurde nur sehr vereinzelt "Arcing" beobachtet. Die Sputterraten waren vergleichbar mit denen, die man für andere ITO-Targets ähnlicher Dichte findet.

**3. Beispiel:**

Für eine 3 % reduzierte ITO(10) Mischung wurden 900 g $In_2O_3$, 50 g $SnO_2$ und 44,7 g SnO während 3h auf einem Rollenbock in einer Trommel gemischt. Das so erhaltene Pulver wurde zunächst kaltisostatisch vorgepreßt und anschließend in einer ausgekleideten Kupferkanne bei 750°C und 200 MPa Druck in einer heißisostatischen Presse kompaktiert. Der erhaltene Indiumoxid-Zinnoxid-Körper hatte eine Dichte von 6,95 g/cm$^3$ entsprechend 97 % der theoretischen Dichte und wies einen Reduktionsgrad von 2,9 % auf. Die mechanische Bearbeitung konnte problemlos durchgeführt werden. Während des Sputterns des Targets wurde kein "Arcing" beobachtet. Die Sputterraten waren vergleichbar mit denen, die man für andere hochdichte teilreduzierte ITO-Targets findet.

**4. Beispiel:**

Für eine 3 % reduzierte ITO(5) Mischung wurden 950 g $In_2O_3$ und 44,7 g SnO während 60 min in einem Taumelmischer gemischt. Das so erhaltene Pulver wurde zunächst kaltisostatisch vorgepreßt und anschließend in einer ausgekleideten Stahlkanne bei 800°C und 200 MPa Druck in einer heißisostatischen Presse kompaktiert. Der erhaltene Indiumoxid-Zinnoxid-Körper hatte eine Dichte von 6,94 g/cm$^3$ entsprechend 97 % der theoretischen Dichte und wies einen Reduktionsgrad von 2,9 % auf. Die mechanische Bearbeitung konnte problemlos durchgeführt werden. Während des Sputterns des Targets wurde kein "Arcing" beobachtet. Die Sputterraten waren vergleichbar mit denen, die man für andere hochdichte teilreduzierte ITO-Targets findet.

**5. Beispiel:**

Für eine 3 % reduzierte ITO(5) Mischung wurden 950 g $In_2O_3$ und 44,7 g SnO während 6h auf einem Rollenbock in einer Trommel gemischt. Das so erhaltene Pulver wurde in eine mit BN beschichtete Graphitform geschüttet und anschließend bei 920°C unter Argonatmosphäre in einer Heißpresse mit einem maximalen Preßdruck von 150 MPa verdichtet. Die so erhaltene Scheibe wies eine Dichte von 6,23 g/cm$^3$ entsprechend 87 % der theoretischen Dichte auf. Der Reduktionsgrad betrug 4 %. Die mechanische Bearbeitung konnte problemlos durchgeführt werden. Während des Sputterns des Targets wurde nur vereinzelt "Arcing" beobachtet. Die Sputterraten waren vergleichbar mit denen, die man für andere ITO-Targets ähnlicher Dichte findet.

**Patentansprüche**

1.  Verfahren zur Herstellung teilreduzierter Sputtertargets für die Kathodenzerstäubung auf der Basis von Indiumoxid-Zinnoxid-Pulvermischungen mittels druckunterstütztem Sintern, wobei $SnO_2$ zusammen mit dem $In_2O_3$ vor dem Verdichten einer Mischbehandlung unterworfen wird, **dadurch gekennzeichnet,** daß die zinnhaltige Komponente vollständig in Abhängigkeit des geforderten Reduktionsgrades aus SnO gebildet ist.

**Claims**

1.  A process for the production of partially reduced sputtering targets for cathode sputtering based on indium oxide/tin oxide powder mixtures by pressure-assisted sintering, wherein $SnO_2$ together with the $In_2O_3$ is subjected to a mixing treatment prior to the compression, characterised in that in dependence upon the required degree of reduction the tin-bearing component is formed entirely from SnO.

**Revendications**

1.  Procédé de production de cibles de pulvérisation cathodique partiellement réduites pour la pulvérisation cathodique à base de mélanges de poudres d'oxyde d'indium et d'oxyde d'étain par frittage assisté par pression où $SnO_2$ est soumis en même temps que $In_2O_3$ à un traitement de mélange avant le compactage, caractérisé en ce que le composant contenant de l'étain est formé par SnO totalement en fonction du degré de réduction exigé.